Europäisches Patentamt

European Patent Office

Office européen des brevets

(11) Numéro de publication: **0 305 228 B1**

(12) **FASCICULE DE BREVET EUROPEEN**

(45) Date de publication de fascicule du brevet: **07.01.93**

(51) Int. Cl.⁵: **H01L 29/08**, H01L 29/812, H01L 29/784, H01L 29/64, H01L 27/08

(21) Numéro de dépôt: **88401745.0**

(22) Date de dépôt: **05.07.88**

(54) **Dispositif semi-conducteur à effet de champ comportant une électrode annexe.**

(30) Priorité: **31.07.87 FR 8710879**

(43) Date de publication de la demande:
**01.03.89 Bulletin 89/09**

(45) Mention de la délivrance du brevet:
**07.01.93 Bulletin 93/01**

(84) Etats contractants désignés:
**DE GB IT NL**

(56) Documents cités:
**US-A- 4 313 126**

**1978 IEEE MTT-S INTERNATIONAL MICROWA-VE SYMPOSIUM DIGEST, Ottawa, 27-29 juin 1978, pages 309-311, IEEE, New York, US; Ph.T. CHEN et al.: "Dual-gate GaAs FET as a frequency multiplier at Ku-band"**

(73) Titulaire: **THOMSON COMPOSANTS MI-CROONDES**
**51, Esplanade du Général de Gaulle**
**F-92800 Puteaux(FR)**

(72) Inventeur: **Delagebeaudeuf, Daniel**
**Thompson CSF SCPI-19, avenue de Messine**
**F-75008 Paris(FR)**
Inventeur: **Derewonko, Henri**
**Thompson CSF SCPI-19, avenue de Messine**
**F-75008 Paris(FR)**
Inventeur: **Godart, Jean-Jacques**
**Thompson CSF SCPI-19, avenue de Messine**
**F-75008 Paris(FR)**
Inventeur: **Resneau, Patrick**
**Thompson CSF SCPI-19, avenue de Messine**
**F-75008 Paris(FR)**
Inventeur: **Gibeau, Pierre**
**Thompson CSF SCPI-19, avenue de Messine**
**F-75008 Paris(FR)**

(74) Mandataire: **Taboureau, James et al**
**THOMSON-CSF SCPI B.P. 329**
**F-92402 COURBEVOIE CEDEX(FR)**

## Description

La présente invention concerne un transistor à effet de champ, dont le gain peut être commandé par une tension continue. Le contrôle du gain est obtenu en séparant la métallisation de drain en deux parties, qui sont séparées entre elles par une métallisation de grille secondaire, constituant une résistance variable qui couple plus ou moins les deux parties du drain. Le transistor selon l'invention possède ainsi deux canaux et deux grilles, mais les deux grilles ne sont pas dans le même canal.

Les transistors à effet de champs bigrilles ou multigrilles sont bien connus, voir par exemple US-A-4 313 216 ou 1978 IEEE MTT-S International Microwave Symposium Digest, Ottawa, Canada 27-29 Juin 1978 (IEEE, New York, 1978), pages 309-311, mais en règles générales, les grilles sont parallèles entre elles et interposées, dans un même canal, entre une source et un drain. En outre, le fait de disposer de plusieurs grilles exerçant leur effet sur un unique canal est utilisé en logique pour réaliser des portes ET par exemple . Lorsque des transistors monogrilles ou bigrilles selon l'art connu sont utilisés pour des fonctions de contrôle de gain, de modulation ou de mélange, ils fonctionnent dans la région de non-linéarité de leur courbe de transconductance, c'est à dire au voisinage du pincement pour un transistor monogrille. Cette région correspond à des transductances faibles, qui évoluent très rapidement en fonction du niveau du signal d'entrée, ce qui entraine soit une dynamique réduite, soit une distorsion non négligeable, et un gain de conversion très faible.

Au contraire, le transistor selon l'invention n'utilise pas la non-linéarité de transductance : par ses deux canaux, il sépare les voies "signal" et "contrôle", et s'il est utilisé en mélangeur par exemple, il opère par multiplication.

Le transistor selon l'invention comporte un corps semiconducteur, composé d'un substrat et de différentes couches dans le détail desquelles il n'est pas nécessaire d'entrer, car l'invention concerne les métallisations de prises de contacts. Sur la surface supérieure de ce corps semiconducteur, et aux emplacements imposés par la structure interne du transistor -selon qu'il comporte des caissons de prises de contacts, une mésa ou un recess etc.. - sont déposées une métallisation de source et une métallisation de grille, qui sont conformes à l'art connu et font partie du transistor principal. Mais la métallisation du drain de ce transistor est divisée en deux parties. Les deux parties de la métallisation de drain n'ont pas de contact entre elles -si ce n'est par le circuit de polarisation extérieure- et la distance qui les sépare est suffisante pour qu'une métallisation de seconde grille y soit insérée : cette seconde grille est dans un canal distinct du canal du transistor principal. Les deux métallisations de drain et la métallisation de seconde grille définissent dans les couches sous-jacentes un transistor à effet de champ secondaire, dont la commande permet de coupler plus ou moins les deux drains.

De façon plus précise, l'invention concerne un dispositif semiconducteur à effet de champ, comportant un corps semiconducteur formé par un substrat et au moins une couche active, ainsi que des métallisations de source, de première grille et de drain qui définissent un transistor principal, caractérisé en ce que la métallisation de drain est formée de deux parties, séparées entre elles par un canal de matériau semiconducteur, sur lequel est déposée une métallisation de seconde grille, les deux parties de métallisation de drain et la métallisation de seconde grille définissant un transistor secondaire, dont le canal est séparé du canal du transistor principal.

L'invention sera mieux comprise par la description détaillée d'un exemple de réalisation, et son fonctionnement et ses avantages ressortiront mieux, à l'aide des figures jointe en annexes qui représentent :

- Figure 1 : vue en plan des métallisations d'un transistor à effet de champ selon l'invention,
- Figure 2 : schéma électrique équivalent du transistor selon l'invention
- Figure 3 : courbe de résistance du canal d'un transistor en fonction de la différence de tension entre grille et drain.
- Figure 4 : courbe de conductance, dans les conditions de la figure 3.
- Figure 5 : courbe de transfert d'un transistor à effet de champ.
- Figure 6 : exemple de variante possible de métallisation d'un transistor selon l'invention.

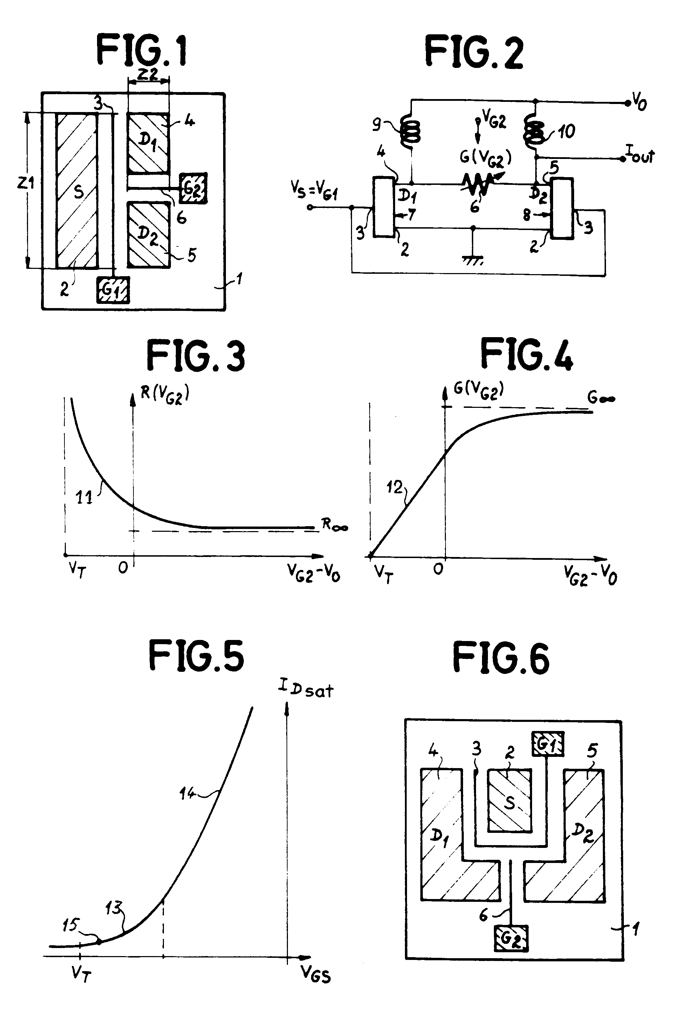

La figure 1 donne une vue en plan d'un transistor selon l'invention, vu par la face qui porte les métallisations des électrodes d'accès. Ce transistor possède un "corps" semiconducteur 1 dans le détail duquel il n'est pas nécessaire d'entrer. Celui-ci peut être en silicium ou en matériaux rapides de la famille III-IV tel que GaAs et sur le substrat sont disposées un certain nombre de couches semiconductrices dans une architecture telle qu'elles composent un transistor. Cette architecture est hors du domaine de l'invention : il suffit qu'elle soit en concordance avec les métallisations de prises de contact dont la représentation donnée ne constitue qu'un exemple non limitatif de l'invention.

Sur la face principale du "corps" semiconducteur 1, et du côté de la ou des couches actives, sont déposées une métallisation de source 2, et une métallisation de grille 3 de largueur $z_1$. Mais, contrairement à l'art connu, la métallisation de drain est séparée en deux métallisations de drain D1 et D2, repérées 4 et 5, qui sont géométriquement isolées: elles laissent entre elles un espace dans lequel est déposée une métallisation 6 de seconde grille G2.

Le canal entre les deux métallisations de drain 4 et 5 peut être effectué en une position quelconque, qui n'est pas obligatoirement au milieu, par rapport à la grille 3. Mais ce canal est distinct par rapport au canal qui supporte la grille 3. Ainsi est défini un second canal, distinct du canal du transistor principal et les métallisations de drain 4 et 5 forment un transistor secondaire, ou de liaison, dont la grille 6 couple plus ou moins les deux parties 4 et 5 du drain. A titre d'exemple non limitatif, le canal du transistor secondaire est représenté, sur la figure 1, perpendiculaire au canal du transistor principal, mais il peut avoir un angle quelconque, ou lui être parallèle : il en est alors séparé par l'une des deux métallisations de drain 4 ou 5.

La figure 2 donne l'équivalent électrique du schéma de la figure 1 : on a deux transistors à effet de champ 7 et 8 -qui constituent le transistor principal 2,3, (4 + 5)- en parallèle, montés en sources 2 communes, ayant même grille 3, mais dont les drains 4 et 5 sont réunis par un transistor de liaison qui se comporte en résistance variable commandée par une tension $V_{G2}$ appliquée sur la seconde grille 6. Bien entendu, pour que le transistor de liaison fonctionne, il faut que les deux métallisations 4 et 5 soient convenablement polarisées, l'une agissant comme source, l'autre agissant comme drain du transistor de liaison.

Plusieurs modes de fonctionnement du transistor selon l'invention sont possibles selon que le transistor de liaison est saturé ou non. Le mode le plus intéressant suppose une différence de potentiel entre les drains D1 et D2 faible à tout instant, en particulier les tensions continues de polarisation des drains D1 et D2 doivent être pratiquement égales, de sorte que seules les différences de potentiel dynamiques faibles $V_{D1} - V_{D2}$ sont prises en considération. Le transistor selon l'invention est donc un transistor faible niveau, mais pas un transistor de puissance.

Cette condition est satisfaite en reliant les drains $D_1$ et $D_2$ à une source de tension commune $V_0$ à travers deux selfs de choc 9 et 10 suffisamment grandes. La grille G2 est reliée à une tension de polarisation $V_{G2}$. Le canal conducteur du transistor de liaison est alors assimilable à une résistance pure de valeur dépendante de la tension $V_{G2} - V_0$ : cette résistance couple plus ou moins les deux drains $D_1$ et $D_2$.

La figure 3 donne l'aspect qualificatif de la variation de cette résistance R en fonction de la différence de tensions $V_{G2} - V_0$, portée en abscisse. L'ordonnée indique la valeur de R pour une tension de commande $V_{G2}$. On sait que R est infinie pour toute valeur de la tension grille inférieure à la tension de seuil $V_T$, et que R tend vers une valeur asymptotique $R_\infty$ pour une valeur infinie de la tension de grille. Le cas représenté est valable pour un transistor normalement bloqué (N-off) mais le raisonnement et la courbe sont transposables pour un transistor normalement passant (N-on). Cette courbe 11 est sensiblement hyperbolique dans sa partie utile entre $V_T$ et une tension finie de la polarisation, et donc de forme 1/x.

Si donc on porte, en figure 4, en fonction de la même variable $V_{G2} - V_0$ la conductance du transistor de liaison,

$$G_{(VG2)} = 1/R_{(VG2)}$$

la courbe 12 est quasiment linéaire dans une plage non-négligeable de la tension $V_{G2} - V_0$. Cette linéarité est d'ailleurs meilleure dans le cas d'un transistor à gaz bidimensionnel d'électrons, de type TEG-FET, que dans le cas d'un transistor à effet de champ à structure classique, à homojonction.

Dans le cas du transistor selon l'invention, tel que schématisé en figure 2, le signal alternatif d'entrée $V_S$ est appliqué sur la première grille $G_1$ - ($V_S = V_{G1}$) du transistor principal, et le signal de sortie $I_{out}$ est prélevé sur l'une des deux métallisations de drain, $D_2$ par exemple. En se plaçant dans les conditions énoncées précédemment (transistor à faible niveau) et en supposant pour simplifier que les éléments réactifs de sortie ($C_{ds}$) puissent être négligés, les composantes variables des courants et tensions sont liées par l'équation :

$$\Delta I_{out} = K (g_m \Delta V_S + g_d \Delta V_{D2})$$

dans laquelle :
$g_m$ est la transductance de chacun des deux transistors actifs,
$g_d$ est la conductance de sortie correspondante,
$\Delta V_S$ est la tension du signal d'entrée
$\Delta V_D$ est la composante alternative de la tension sur le drain,
K est un terme modulant, facteur multiplicatif du courant de sortie, fonction de la tension de contrôle $V_{G2}$, et défini par

$$K = \frac{2 \dfrac{G_{(VG2)}}{g_d} + 1}{\dfrac{G_{(VG2)}}{g_d} + 1}$$

dans laquelle G est la conductance du transistor de liaison, ou secondaire.

Si $G_{VG2} = \infty$, K = 2 : les drains D1 et D2 sont courts-circuités par un canal secondaire conducteur, de résistance nulle, et on se trouve dans le cas où les deux transistors principal et secondaire additionnent seulement leurs contributions : le transistor fonctionne comme un transistor ordinaire, n'ayant qu'un seul drain.

Dans le cas plus général où $G_{VG2}$ a une valeur finie, déterminée selon la partie linéaire de la droite 12 en figure 4, tout se passe comme si les largeurs $Z_1$ et $Z_2$ cumulées des grilles des deux transitors étaient multipliées par un facteur K, compris entre 1 et 2 et fonction de la tension de contrôle $V_{G2}$.

En outre, le calcul montre qu'à tension de contrôle $V_{G2}$ donnée, le facteur K dépend essentiellement du rapport $Z_1 / Z_2$ des largeurs de grilles $G_1$ et $G_2$ des transistors principal et secondaire. Ce facteur K peut donc être ajusté par construction, la largeur $Z_1$ étant imposée par les caractéristiques d'utilisation du transistor principal, on peut toujours donner aux métallisations de drain $D_1$ et $D_2$ des dimensions qui permettent d'obtenir pour la grille $G_2$ la largeur $Z_2$ désirée.

Une première application du dispositif selon l'invention est le contrôle de gain. En effet, le transistor selon l'invention constitue un transistor à gain variable, commandable par la tension $V_{G2}$ appliquée sur la grille du transistor secondaire : en faisant varier la tension de contrôle $V_{G2}$, on fait varier le gain du transistor principal. Compte tenu de la technologie actuelle, et des tensions finies qu'on peut réellement appliquer à un transistor, une variation d'environ 3 dB est possible sur le gain en puissance.

Une deuxième application du dispositif selon l'invention est la modulation d'amplitude. Sur la grille G2 du transistor de liaison est appliquée une tension variable, qui module le signal $V_S$ adressé sur la grille G1 du transistor principal. Dans ce cas, il est préférable de concevoir le dispositif et de polariser en conséquence le transistor secondaire pour que :

$$\frac{G_{(VG2)}}{g_d} \leq 0.5$$

valeur pour laquelle la profondeur de modulation, dans la couche active, est quasiment linéaire en fonction de la tension de modulation $V_{G2}$.

L'application la plus intéressante du dispositif selon l'invention concerne le mélange de fréquences de signaux, entre un signal d'entrée $V_S$ adressé sur la première grille G1 et un signal d'oscillateur local par exemple adressé sur la deuxième grille G2.

L'intérêt de ce mélangeur ressortira mieux par le rappel préliminaire des conditions de mélange dans un transistor selon l'art connu. La figure 5 donne la courbe de transfert d'un transistor à effet de champ classique, soit le courant de drain $I_{D\ sat}$ en fonction de la différence de potentiel entre grille et source $V_{GS}$. Cette courbe comprend une partie 13 qui est quadratique, donc non linéaire, et une partie 14 qui tend vers la linéarité.

Pour un transistor monogrille ou bigrille classique, le mélange ne peut se faire que dans la partie non linéaire. En effet, on comprend facilement qu'il faut que l'équation de la courbe de transfert soit de la forme $m = (a + b)^n$, avec n = 2,3,4... pour avoir des termes en nab. Si n = 1, il n'y a pas mélange de fréquences. Donc avec un transistor classique, on polarise la ou les grilles de telle façon que le transistor travaille dans une région de non-linéarité maximale : par exemple au voisinage de la tension de pincement $V_T$ en un point tel que 15.

Mais ceci présente deux inconvénients. D'abord, ces conditions de polarisation correspondent à des transconductances relativement faibles et qui évoluent très rapidement en fonction du niveau d'un signal d'entrée (variation de $V_{GS}$), entrainant une dynamique très réduite, ou une distorsion importante, et en tous cas un gain de conversion très faible.

Ensuite, un tel fonctionnement génère un grand nombre d'harmoniques haute ou basse fréquence, d'autant plus grand que l'indice n de non-linéarité est important. Il est donc nécessaire de filtrer les harmoniques non désirées.

Ces inconvénients proviennent de ce qu'on utilise le même canal conducteur, entre source et drain, pour assurer plusieurs fonctions différentes. S'il y a plusieurs grilles, elles sont disposées en parallèles sur cet unique canal.

Au contraire, dans le dispositif selon l'invention, les voies "signal" et "contrôle" sont nettement séparées, dans deux canaux qui sont séparés entre eux, et le mélange des voies s'opère par produit, ou par multiplication (facteur K), dans des conditions telles que la transconductance est linéaire (droite 12 de la figure 4). Si l'on convient de considérer le transistor principal comme étant la voie "signal", la transconductance de la voie signal peut être réglée par une polarisation adéquate pour avoir un maximum de performances : on a ainsi un gain de conversion non négligeable.

Par ailleurs, soit $\omega_S$ la fréquence angulaire d'un signal adressé sur la première grille $G_1$ et $\omega_{ol}$ la fréquence angulaire de l'oscillateur local adressé sur la deuxième grille G2. Du fait de la caractéristique quasi-linéaire de G(VG2) en fonction de $V_{G2}$ -

et pour une polarisation continue convenable de la grille G2 -le mélangeur selon l'invention ne génère, outre $\omega_S$ et $\omega_{ol}$, que les fréquences $\omega_{ol} - \omega_S$ et $\omega_{ol} + \omega_S$, quel que soit le niveau de l'oscillateur local. Si par exemple $\omega_{ol} - \omega_S$ est la fréquence recherchée $\omega_{ol} + \omega_S$ est appelée sa fréquence image. Le mélangeur selon l'invention fournit donc un spectre, qui ne comporte qu une fréquence de mélange et sa fréquence image : les problèmes de filtrage s'en trouvent simplifiés.

La géométrie des métallisations d'électrodes du transistor selon l'invention n'est pas limitée à celle qui est représentée en figure 1. Un autre exemple en est donné en figure 6, dans lequel la région de drain et ses électrodes D1 et D2 entourent la région de source : bien entendu, la structure interne de transistor doit correspondre à la géométrie des électrodes. Dans ce second exemple, le drain est, conformément à l'invention, coupé en deux parties, séparées, par un canal qui est sensiblement perpendiculaire au canal du transistor principal. D'autres configurations sont possibles, et le canal secondaire peut présenter un angle différent par rapport au canal principal : l'important est que les deux canaux soient nettement séparés, et travaillent indépendamment.

L'application de cette configuration aux transistors interdigités est possible si le transistor ne comporte pas un nombre élevé de doigts, et reste dans le domaine des transistors de petits signaux.

La structure de métallisations selon l'invention est applicable à tous les transistors fonctionnent à basse fréquence, en silicium, ou à hautes fréquences, en matériaux rapides de la famille III - IV tel que GaAs. Toutefois, elle est plus particulièrement intéressante lorsque le corps semiconducteur du transistor comporte une hétérojonction avec présence d'un gaz bidimensionnel d'électrons.

Ces transistors sont utilisés notamment en télécommunications et en traitement de signal, dans les radars par exemple, pour la modulation d'amplitude et le mélange de fréquences.

**Revendications**

1.  Dispositif semiconducteur à effet de champ, comportant un corps semiconducteur (1) formé par un substrat et au moins une couche active, ainsi que des métallisations de source (2), de première grille (3) et de drain (4 + 5) qui définissent un transistor principal, caractérisé en ce que la métallisation de drain est formée de deux parties (4 et 5), séparées entre elles par un canal de matériau semiconducteur, sur lequel est déposée une métallisation de seconde grille (6), les deux parties (4 et 5) de métallisation de drain et la métallisation de seconde grille (6) définissant un transistor secondaire, dont le canal est séparé du canal du transistor principal.

2.  Dispositif selon la revendication 1, caractérisé en ce que les deux métallisations de drain (4,5) sont polarisées par une tension continue $V_0$ à travers deux selfs de choc (9,10) de valeur élevée, et en ce que la seconde grille (6) est polarisée par une tension de contrôle $V_{G2}$.

3.  Dispositif selon la revendication 1, caractérisé en ce que le transistor secondaire (4 + 5 + 6) se comporte comme une résistance variable, qui couple les deux parties (4 et 5) de la métallisation de drain, le couplage étant fonction de la différence de potentiels $V_{G2} - V_0$.

4.  Dispositif selon la revendication 2, caractérisé en ce que le gain du transistor principal (2 + 3 + 4,5) est contrôlé par la tension $V_{G2}$ appliquée sur la grille (6) du transistor secondaire (4 + 5 + 6).

5.  Dispositif selon la revendication 2, caractérisé en ce que l'amplitude du signal de sortie $I_{out}$ du transitor principal (2 + 3 + 4,5) est modulée par une tension $V_{G2}$ variable, appliquée sur la grille (6) du transistor secondaire (4 + 5 + 6).

6.  Dispositif selon la revendication 2, caractérisé en ce qu'il constitue un mélangeur de fréquences entre un signal $V_S$ appliqué sur la première grille (3) et un signal $V_{G2}$ appliqué sur la deuxième grille (6).

**Claims**

1.  A field-effect semiconductor device, comprising a semiconductor body (1) formed by a substrate and at least one active layer, and also source (2), first grid (3) and drain (4 + 5) metallisations, which define a principal transistor, characterised in that the drain metallisation is formed of two parts (4 and 5), separated from each other by a canal of semiconductor material, on which there is deposited a second grid metallisation (6), the two parts (4 and 5) of the drain metallisation and the second grid metallisation (6) defining a secondary transistor, the canal of which is separated from the canal of the principal transistor.

2.  A device according to Claim 1, characterised in that the two drain metallisations (4,5) are polarised by a continuous voltage $V_0$ through two high value shock self-induction coils (9,10), and in that the second grid (6) is polarised by a control voltage $V_{G2}$.

3. A device according to Claim 1, characterised in that the secondary transistor (4 + 5 + 6) acts as a variable resistance, which couples the two parts (4 and 5) of the drain metallisation, the coupling being a function of the difference of potentials $V_{G2}$ - $V_0$.

4. A device according to Claim 2, characterised in that the gain of the principal transistor (2 + 3 + 4, 5) is controlled by the voltage $V_{G2}$ applied on the grid (6) of the secondary transistor (4 + 5 + 6).

5. A device according to Claim 2, characterised in that the amplitude of the output signal $I_{out}$ of the principal transistor (2 + 3 + 4,5) is modulated by a variable voltage $V_{G2}$, applied on the grid (6) of the secondary transistor (4 + 5 + 6).

6. A device according to Claim 2, characterised in that it constitutes a mixer of frequencies between a signal $V_S$ applied on the first grid (3) and a signal $V_{G2}$ applied on the second grid (6).

**Patentansprüche**

1. Feldeffekt-Halbleitervorrichtung mit einem Halbleiterkörper (1), der von einem Substrat und mindestens einer aktiven Schicht gebildet wird, sowie mit Metallbelägen für die Source (2), das erste Gate (3) und den Drain (4 und 5), die einen Haupttransistor definieren, dadurch gekennzeichnet, daß der Drainmetallbelag aus zwei Bereichen (4 und 5) gebildet wird, die voneinander durch einen Kanal aus Halbleitermaterial getrennt sind, auf den ein Metallbelag eines zweiten Gates (6) aufgebracht ist, wobei die beiden Bereiche (4 und 5) des Drainmetallbelags und der Metallbelag des zweiten Gates (6) einen Sekundärtransistor definieren, dessen Kanal vom Kanal des Haupttransistors getrennt ist.

2. Vorrichtung nach Anspruch 1, dadurch gekennzeichnet, daß die beiden Drainmetallbeläge (4, 5) mit einer Gleichspannung $V_0$ über zwei Stoßinduktanzen (9, 10) hohen Werts vorgespannt werden und daß das zweite Gate (6) mit einer Steuerspannung ($V_{G2}$) vorgespannt wird.

3. Vorrichtung nach Anspruch 1, dadurch gekennzeichnet, daß der Sekundärtransistor (4 + 5 + 6) sich wie ein variabler Widerstand verhält, der die beiden Teile (4 und 5) des Drainmetallbelags koppelt, wobei die Kopplung von der Potentialdifferenz $V_{G2}$ - $V_0$ abhängt.

4. Vorrichtung nach Anspruch 2, dadurch gekennzeichnet, daß der Verstärkungsgrad des Haupttransistors (2 + 3 + 4,5) durch die an das Gate (6) des Sekundärtransistors (4 + 5 + 6) angelegte Spannung $V_{G2}$ gesteuert wird.

5. Vorrichtung nach Anspruch 2, dadurch gekennzeichnet, daß die Amplitude des Ausgangssignals $I_{out}$ des Haupttransistors (2 + 3 + 4,5) mit einer variablen Spannung $V_{G2}$ moduliert wird, die an das Gate (6) des Sekundärtransistors (4 + 5 + 6) angelegt wird.

6. Vorrichtung nach Anspruch 2, dadurch gekennzeichnet, daß sie einen Frequenzmischer zwischen einem Signal $V_S$, das an das erste Gate (3) angelegt wird, und einem Signal $V_{G2}$ bildet, das an das zweite Gate (6) angelegt wird.

# FIG.1

# FIG.2

# FIG.3

# FIG.4

# FIG.5

# FIG.6